# EUROPEAN PATENT SPECIFICATION

(11) **EP 0 347 853 B1**
(45) Date of publication and mention of the grant of the patent: **02.02.2000**
(21) Application number: 89111233.6
(22) Date of filing: 20.06.1989
(51) Int. Cl.: H01L 27/02, H01L 23/52, H04S 1/00

(54) **Semiconductor integrated circuit**
Integrierte Halbleiterschaltung
Circuit intégré semi-conducteur

(30) Priority: 21.06.1988 JP 15312288; 12.07.1988 JP 17300388; 12.07.1988 JP 17300488; 12.07.1988 JP 17300588; 12.07.1988 JP 17300988; 12.07.1988 JP 17301088; 12.08.1988 JP 20219688; 20.09.1988 JP 23582888
(43) Date of publication of application: 27.12.1989
(73) Proprietor: SANYO ELECTRIC CO., LTD., Moriguchi-shi, Osaka (JP)
(72) Inventor: Tomizuka, Kazuo, Gunma-ken (JP); Sugayama, Sakae, Oizumimachi Ora-gun Gunma-ken (JP); Saeki, Takao, Gunma-ken (JP); Imai, Toshiaki, Ota-shi Gunma-ken (JP)
(74) Representative: Glawe, Delfs, Moll & Partner

(56) References cited:
- DE-A- 2 017 607
- PATENT ABSTRACTS OF JAPAN vol. 12, no. 189 (E-616)(3036) 2 June 1988 & JP-A-62 293 660 ( HITACHI LTD. ) 21 December 1987
- PROCEEDINGS OF THE 1985 CUSTOM INTEGRATED CIRCUITS CONFERENCE 20 May 1985, OREGON US pages 68 - 71; H. CAI: 'An automatic routing system for general cell VLSI circuits'
- PATENT ABSTRACTS OF JAPAN vol. 6, no. 173 (E-129)(1051) 7 September 1982 & JP-A-57 089 345 ( HITACHI SEISAKUSHO K.K. ) 3 June 1982
- PATENT ABSTRACTS OF JAPAN vol. 11, no. 244 (E-530)(2691) 8 August 1987 & JP-A-62 054 950 ( MITSUBISHI ELECTRIC CORP. ) 10 March 1987
- PATENT ABSTRACTS OF JAPAN vol. 11, no. 220 (E-524)(2667) 16 July 1987 & JP-A-62 038 046 ( TOSHIBA CORP. ) 19 February 1987

## Description

### BACKGROUND OF THE INVENTION

### Field of the Invention

The present invention relates to semiconductor integrated circuits (ICs) and particularly to a semiconductor IC having a pattern layout applicable to various custom ICs.

### Description of the Background Art

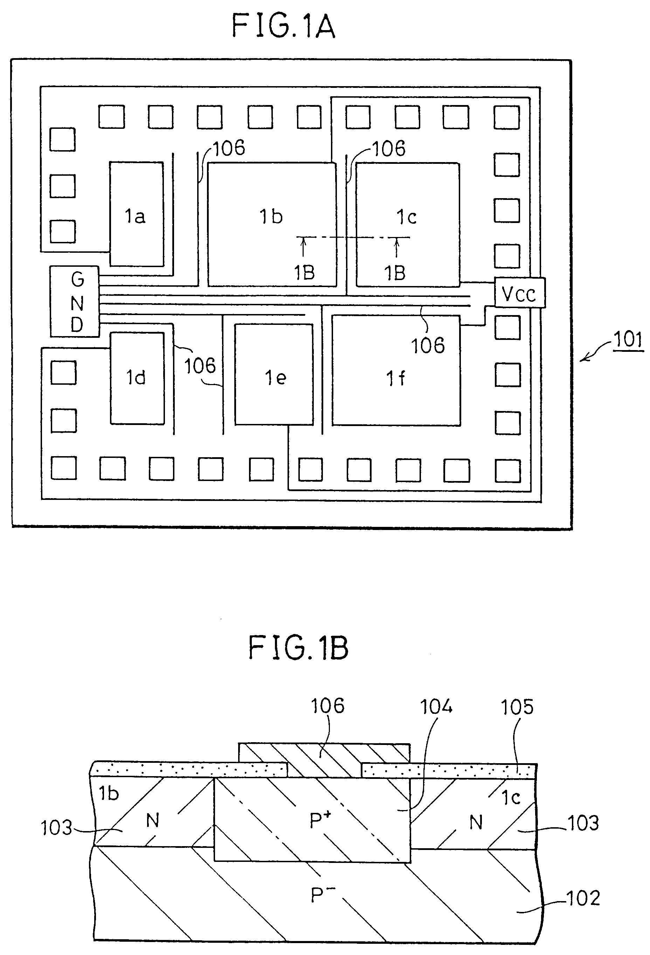

Fig. 1A is a schematic top view showing an example of a pattern layout of a conventional semiconductor IC and Fig. 1B is a schematic sectional view taken along the line 1B-1B in Fig. 1A. Referring to those figures, a semiconductor chip 101 comprises circuit blocks 1a to 1f. Each of those circuit blocks is formed in an epitaxial N layer 103 on a P⁻ semiconductor substrate 102 and surrounded by P⁺ separation regions 104. The epitaxial layer 103 is covered with an oxide film 105. Ground lines 106 penetrate the oxide film 105 and they are in ohmic contact with the P⁺ separation regions 104, whereby potentials of the P⁺ separation regions 104 and P⁻ substrate 102 are stably set to a ground potential.

A bundle of ground lines 106 extend from a ground bonding pad GND provided on the left of the semiconductor chip 101 through a central region of the semiconductor chip 101 and the ground lines 106 are distributed from the bundle to the corresponding circuit blocks 1a to 1f. Power supply lines extend from a power supply bonding pad Vcc provided on the right of the semiconductor chip 101 to peripheral regions of the semiconductor chip 101 so that they are connected to the corresponding circuit blocks.

In general, signals processed in the circuit blocks 1a to 1f have different frequencies and amplitude levels and those circuit blocks 1a to 1f have different functions. Thus, the circuit blocks 1a to 1f have different numbers of circuit elements and they have different areas. Accordingly, it is not easy to arrange efficiently the circuit blocks 1a to 1f having different areas in a small area. In addition, if the circuit block 1a for example is replaced by a modified circuit block (having a different area from the circuit block 1a) or a new circuit block is added, it is often necessary to rearrange all the circuit blocks 1a to 1f in order to set such a modified or new circuit block efficiently in a reduced area.

Further, in the case of arranging the circuit blocks, it is desirable to reduce the total area occupied by those circuit blocks and at the same time it is necessary to take measures to minimize undesirable mutual interferences of the circuit blocks. Consequently, for example in the case of changing part of a certain IC device in compliance with a request of a user, it is often necessary to entirely change the design of the circuit block pattern, which takes time and involves considerable cost.

### SUMMARY OF THE INVENTION

A semiconductor integrated circuit device is disclosed in DE-A-2 017 607. This semiconductor integrated circuit is a digital circuit manufactured by a master slice method with unit cells, wherein the unit cells are combined by a wiring to realize a specific circuit construction.

"Proceedings of the IEEE 1985 custom integrated circuit conference", 20-23 May 1985, Portland, Oregon, USA, pages 68-71, discloses an automatic routing system, wherein circuit blocks having different functions and configurations are arranged in layout areas having different shapes and sizes. In sofar, this construction corresponds to the prior art as mentioned above.

JP-A-62012147 discloses a master slice type semiconductor device wherein circuit blocks having different functions are shielded from each other.

It is an object of the invention to provide a semiconductor IC having a pattern layout applicable to various custom ICs.

Another object of the invention is to provide a semiconductor IC in which mutual interferences of circuit blocks are minimized.

These objects are achieved by a semiconductor integrated ciruit as defined in claim 1; the remaining claims relate to further developments of the invention.

In the following description, the layout areas are referred to as "mats".

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1A is a schematic top view showing an example of a pattern layout of a conventional semiconductor IC.
Fig. 1B is a schematic sectional view taken along the line 1B-1B in Fig. 1A.
Fig. 2 is a top view showing schematically a pattern layout of a semiconductor IC according to an embodiment of the present invention.
Fig. 3A is a an enlarged detailed view of a part of Fig. 2.
Fig. 3B is sectional view taken along the line 3B-3B in Fig. 3A.
Fig. 4 is a circuit block diagram showing an example of an AM/FM stereo tuner.
Fig. 5A is an enlarged detailed view of a part of Fig. 2.
Fig. 5B is a sectional view taken along the line 5B-5B in Fig. 5A.
Fig. 5C is a sectional view taken along the line 5C-5C in Fig. 5A.
Fig. 6 is a schematic top view of a semiconductor IC according to another embodiment of the present invention.
Fig. 7A is a sub block diagram showing details of an AM tuner block.
Fig. 7B is a sub block diagram showing details of an FM front end block and an FM-IF block.
Fig. 7C is a sub block diagram showing details of a multiplex decoder block.
Fig. 8 is a top view showing a positional relation of circuit blocks of an AM/FM tuner formed on a semiconductor chip.
Fig. 9 is a top view showing an arrangement of a plurality of elongate dummy islands.
Fig. 10 is a top view showing schematically a 2-level crossing of power supply lines and ground lines in the semiconductor IC of Fig. 6.
Fig. 11A is a schematic top view of a semiconductor IC according to a further embodiment of the present invention.
Fig. 11B is a schematic top view of a semiconductor IC according to a still further embodiment of the present invention.

### DESCRIPTION OF THE PREFERRED EMBODIMENTS

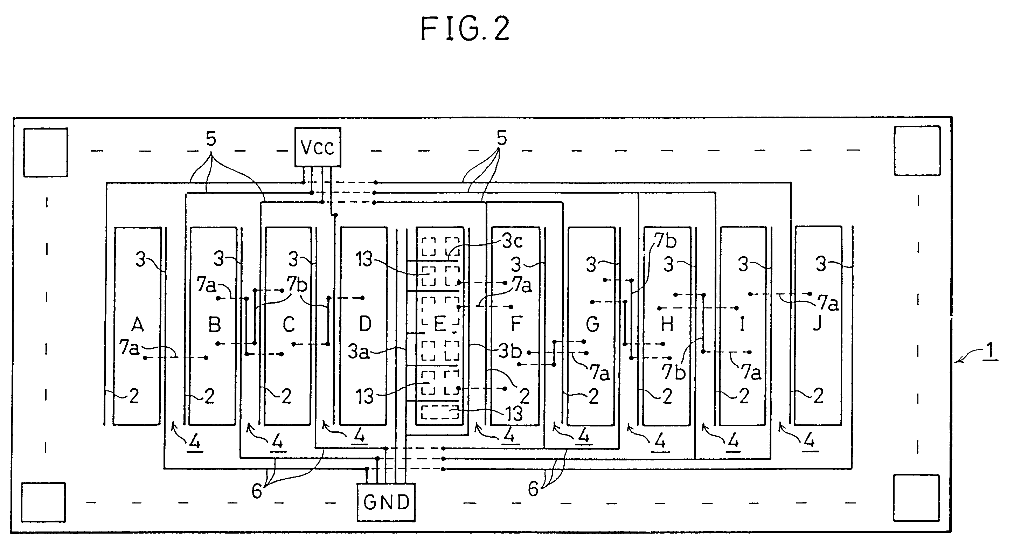

Referring to Fig. 2, a surface pattern of a semiconductor IC according to an embodiment of the present invention is schematically shown. Mats A to J separated from each other by partition belts 4 are provided on a semiconductor chip 1 and a plurality of circuit elements are formed in each of those mats A to J. Power supply lines 2 and ground lines 3 parallel to each other are normally provided on the respective partition belts 4. A power supply line 2 is provided adjacent to the left side of each of the mats A to J and a ground line 3 is provided adjacent to the right side thereof. Accordingly, only one power supply line exists on the left side of the mat A at the left end and only one ground line 3 exists on the right side of the mat J at the right end.

A bundle 5 of power supply lines extends from a power supply pad Vcc along an upper side of the semiconductor chip 1 in the figure and each of the power supply lines 2 on the partition belts 4 is connected to the corresponding power supply line of the bundle 5. Similarly, a bundle 6 of ground lines extends from a ground pad GND along a lower side of the semiconductor chip 1 and each of the ground lines 3 on the partition belts 4 is connected to the corresponding one of the ground lines of the bundle 6. In other words, the power supply lines and the ground lines have comb-like forms and those two comb-like forms are opposed to each other with the teeth of one of them being inserted between the respective adjacent teeth of the other. Accordingly, pluralities of mats, power supply lines, ground lines and the like can be arranged efficiently in a compact manner in a small area.

Those power supply lines 2 and 5 and ground lines 3 and 6 are formed substantially in a first layer of two conductor layers. However, as shown by the broken lines near the power supply pad Vcc and the ground pad GND, the power supply lines 5 and ground lines 6 are partially continuous with each other through a second layer in order to accomplish 2-level crossing. The small black dots at the respective ends of the broken lines represent connections of the conductors of the first and second layers.

The mats A to J have substantially the same rectangular form and size. For example, a shorter side of each mat is set to a dimension making it possible to arrange six bipolar transistors. A longer side of each mat is set to a dimension making it possible for the mat to contain about 100 circuit elements, easy to handle in design. However, the mat size can be set to an arbitrary size which can contain a preferable number of circuit elements according to circuit blocks incorporated in an IC device.

Circuit elements such as transistors, diodes, resistors and capacitors can be integrated in each mat and those circuit elements are separated from each other by normal PN junction. The circuit elements are interconnected substantially by the conductors in the first layer and partially by the conductors in the second layer to accomplish the 2-level crossing.

The circuit elements in the different mats are interconnected substantially through the conductors in the second layer as shown by the broken lines 7a in Fig. 2 and those conductors 7a cross over the power supply lines 2 and the ground lines 3. The conductors 7a in the second layer can be also connected by means of conductor segments 7b in the first layer represented as short solid lines between the power supply lines 2 and ground lines 3 parallel with each other in order to attain the 2-level crossing between the conductors 7a, while avoiding mutual interference with the circuit elements in the mats.

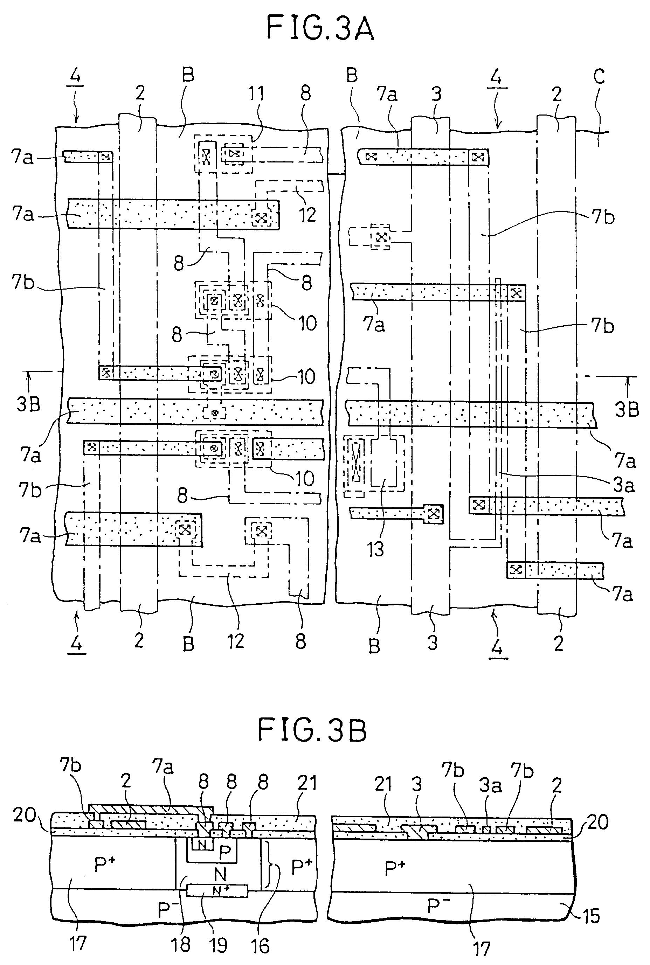

Referring to Fig. 3A, a top view of a region near the mat B is partially shown in an enlarged manner. The conductors 2, 3, 3a, 7b, 8 represented by the chain lines exist in the first layer and the conductors 7a smudged and surrounded by the solid lines exist in the second layer. The conductors 2, 3, 3a, 7b, 8 in the first layer and the conductors 7a in the second layer can be connected through contact regions represented by the marks x. The mat B exists between the power supply line 2 on the left side and the ground line 3 on the right side and the circuit elements such as transistors 10, diodes 11, resistors 12 and capacitors 13 represented by the broken lines are formed in the mat B. Although those circuit elements 10 to 13 are roughly shown for the purpose of clarifying the drawing, they are in reality integrated with high density.

As described above, the conductors 7a in the second layer are used for the interconnections of the mats, e.g., signal lines or feedback lines. The conductors 7a in the second layer are arranged in parallel with each other in order to avoid mutual crossing on the plane. In order to make possible the 2-level crossing of those conductors 7a, the conductor segments 7b between the power supply lines 2 and the ground lines 3 in the partition belts 4 can be utilized. If it is necessary to prevent mutual interference between the respective adjacent two conductor segments 7b, conductors 3a derived from the ground line 3 (or the power supply line 2) are provided between the respective two adjacent conductor segments 7b so that the mutual interference can be reduced. Further, the power supply line 2 and the ground line 3 serve to reduce mutual interference between the conductor segments 7b and the mat adjacent thereto.

Referring to Fig. 3B, a sectional view taken along the line 3B-3B in Fig. 3A is schematically shown. An N epitaxial layer 16 is formed on a P⁻ semiconductor substrate 15. A large number of islands 18 surrounded by P⁺ separation regions 17 are formed in the epitaxial layer 16. Each of the circuit elements such as the NPN transistors 10, the diodes 11, the resistors 12 and the capacitors 13 is formed in each one of those islands 18. A burried N⁺ region 19 is formed between a collector N region 18 of each NPN transistor 10 and the P⁻ substrate. The epitaxial layer 16 is covered with a silicon oxide film 20 formed by chemical vapor deposition (CVD) for example. Conductors 2, 3, 3a, 7b, 8 in the first layer are formed on the silicon oxide film 20 and those conductors are covered with an insulating film 21 of polyimide resin or the like. Conductors 7a in the second layer are formed on the insulating film 21.

The power supply lines 2 and the ground lines 3 are provided above the P⁺ separation regions 17. The ground lines 3 penetrate the silicon oxide film 20 along the longitudinal direction thereof and they are in ohmic contact with the P⁺ separation regions 17, so that the substrate 15 is stably set at a ground potential.

In the following, an example of a relation between the electronic circuit blocks and the mats A to J incorporated in the semiconductor chip in Fig. 2 will be described.

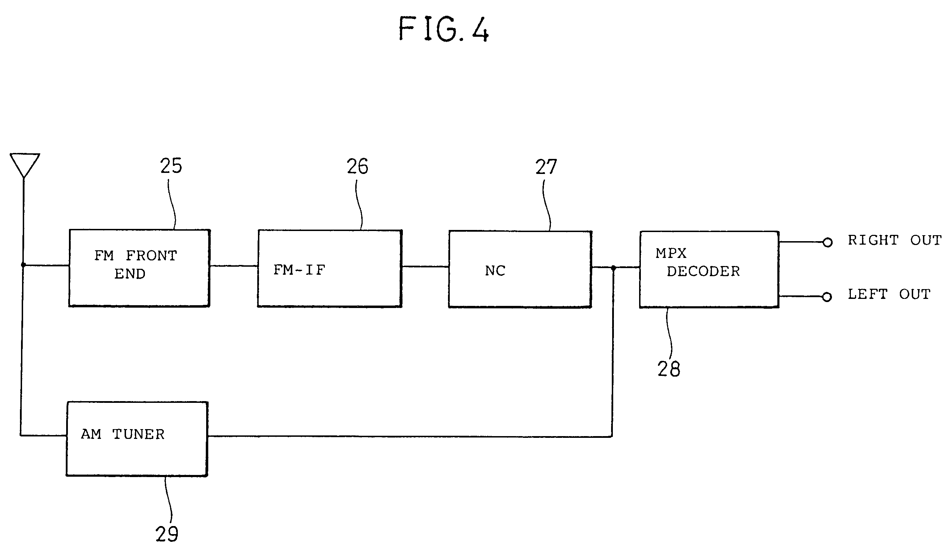

Fig. 4 is a circuit block diagram showing an example of an AM/FM stereo tuner. An FM front end block 25 includes about 250 circuit elements and it receives an FM broadcasting signal of several tens of MHz to several hundreds of MHz and convert it to an intermediate frequency signal of 10.7 MHZ. An FM-IF block 26 includes about 430 circuit elements and it amplifies the intermediate frequency signal and detects the amplified signal so that an audio signal is obtained. A noise canceller block 27 includes about 270 circuit elements and it removes pulse noise such as ignition noise. A multiplex decoder block 28 includes about 390 circuit elements and it divides a stereo composite signal into right and left channel signals so as to output a stereo signal. An AM tuner block 29 includes about 350 circuit elements and it converts a received AM signal to an intermediate frequency signal (of 450 KHz) and detects the converted signal so that an audio output is obtained.

When the multiplex decoder block 28 and the FM-IF block 26 are to be incorporated in the semiconductor chip shown in Fig. 2, the multiplex decoder block 28 including about 390 circuit elements is divided into four portions each including less than 100 circuit elements and each of those four portions is formed in the corresponding one of the mats A, B, C, D. As described previously, the mats A to D are interconnected by means of the conductors 7a and 7b as shown in Fig. 3A. Similarly, the FM-IF block 26 including about 430 circuit elements is divided into five portions each including less than 100 circuit elements and each of those five portions is formed in the corresponding one of the mats E, F, G, H, I. The remaining mat J can be used for an optional circuit requested by the user and, for example, it can be used for a circuit for improving characteristics of an arbitrary circuit block.

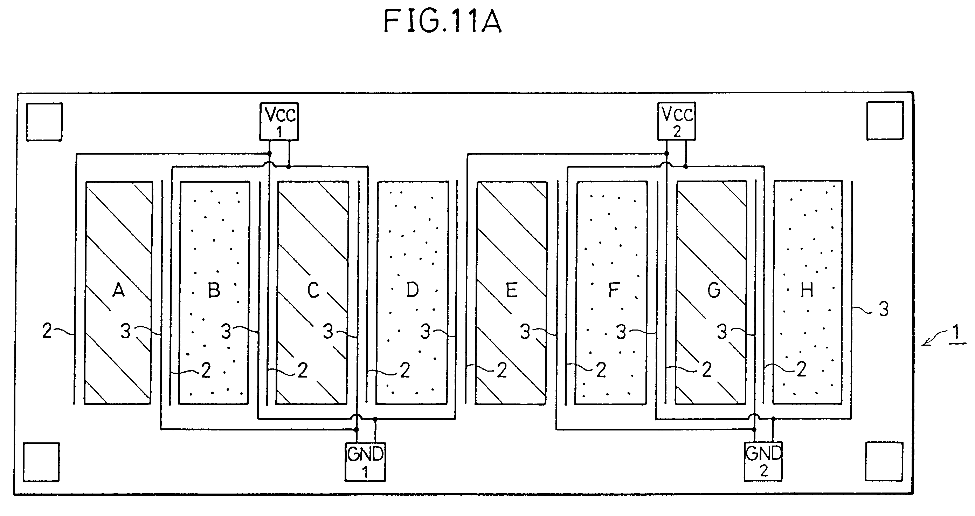

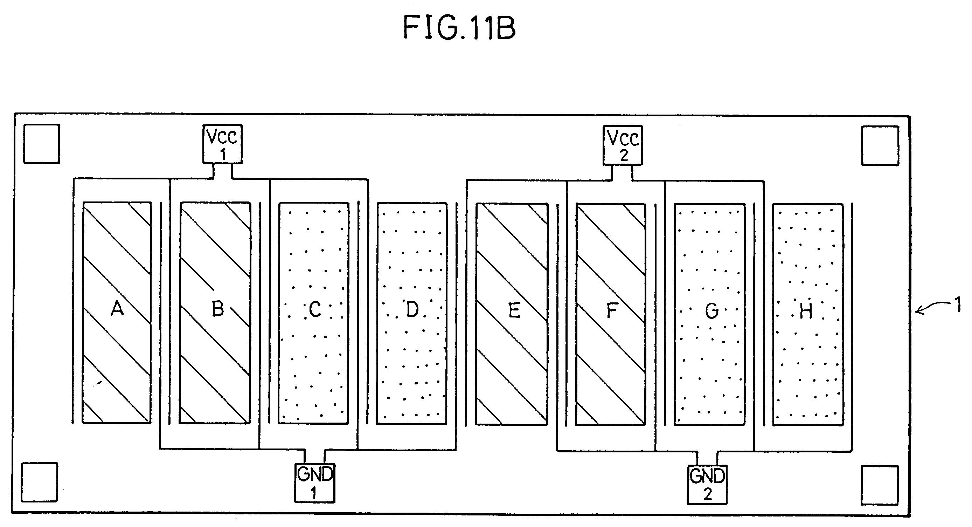

Capacitors 13 included in the FM-IF block 26 are integrated in the mat E. Referring to Fig. 2, 11 capacitors are schematically shown by the broken lines in the mat E. Ground lines 3a and 3b are provided on both sides of the mat E so as to absorb leakage current generated from regions near those capacitors 13. A plurality of ground lines 3c having a comb teeth form for enhancing efficiency of absorption of the leakage current extend from the ground lines 3a.

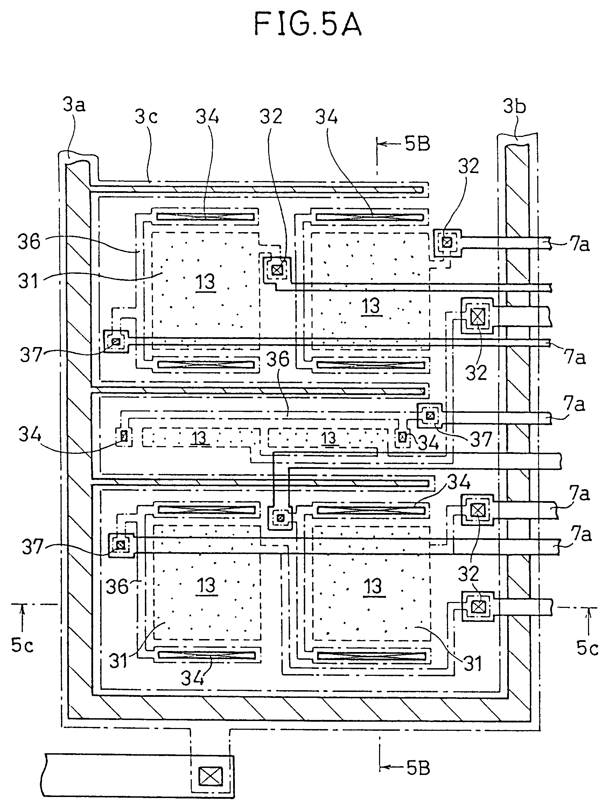

Referring to Fig. 5A, a part of the mat E in Fig. 2 is shown in an enlarged manner. A plurality of metal-oxide semiconductor (MOS) capacitors 13 are formed between the ground lines 3a and 3b shown by the chain lines. The ground lines 3a, 3b and 3c shown by the chain lines are in ohmic contact with P⁺ separation regions under those lines in hatched regions. Smudged regions of the capacitors 13 represent upper capacitor electrodes 31. The upper capacitor electrodes 31 are formed in the first conductor layer and they are connected to the conductors 7a in the second layer represented by the solid lines through contact regions 32 shown by the marks x. The conductors 7a in the second layer cross over the ground lines 3b and extend rightward so as to be introduced into any of the mats F-I.

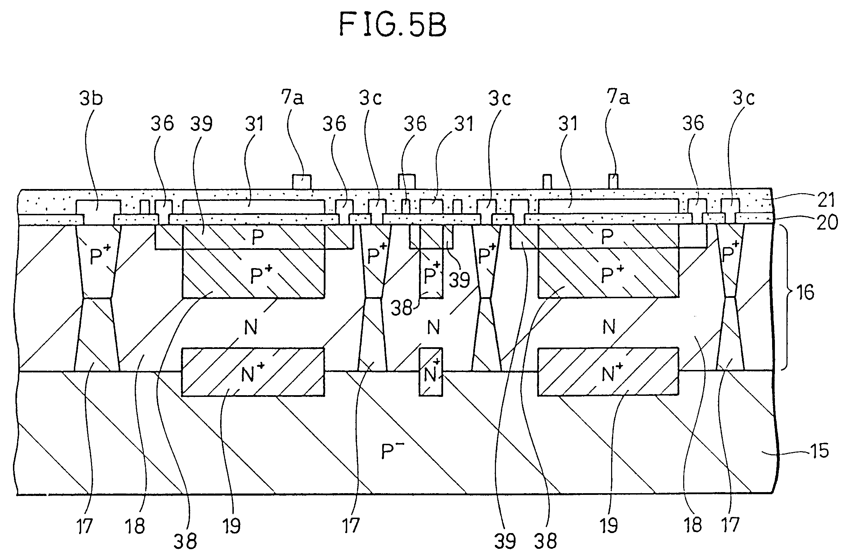

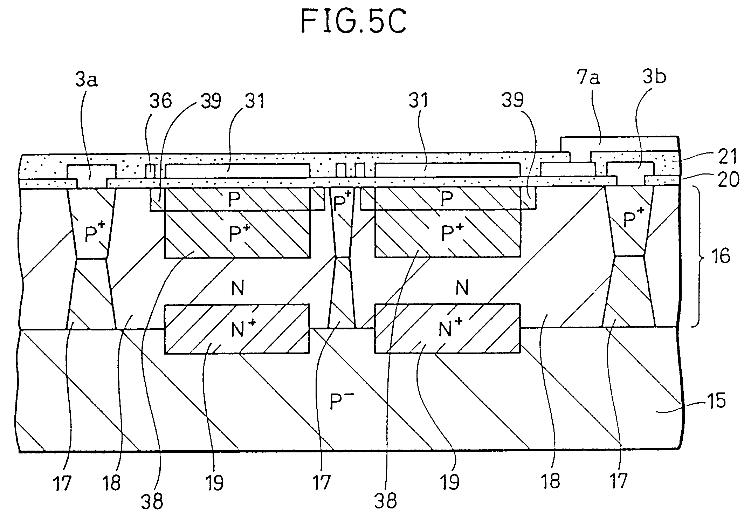

Lower capacitor electrodes (shown in Figs. 5B and 5C) opposed to the upper capacitor electrodes 31 are connected to lower capacitor electrode connectors 36 through contact regions 34 and the connectors 36 are connected to the conductors 7a in the second layer through contact regions 37.

Figs. 5B and 5C show schematic sectional views taken along the lines 5B-5B and 5C-5C in Fig. 5A, respectively. Referring to Figs. 5B and 5C, P⁻ semiconductor substrate 15, an epitaxial N layer 16, P⁺ separation regions 17, N islands 18, burried N⁺ layers 19, a silicon oxide film 20 and an insulating film 21 of such as polyimide resin are formed in the same manner as in Fig. 3B. However, P⁺ diffusion regions 38 are formed on respective surfaces of N islands 18 and P diffusion regions 39 overlapping with main portions of the P⁺ regions 38 are further formed. Thus, the P regions 38 and 39 constitute the lower capacitor electrodes opposed to the upper capacitor electrodes 31 and they are connected to the respective connectors 36.

In vicinities of the MOS capacitor 13 thus formed, leakage currents from junction capacitors formed by reverse bias of the PN junctions between the separation regions 17 and the islands 18, between the substrate 15 and the islands 18 and between the substrate 15 and the burried layers 19 can be absorbed reliably by the ground lines 3a, 3b, 3c through the separation regions. Consequently, the leakage current from the regions near the capacitors 13 never exert any adverse influence on the circuit elements of the adjacent mats D and F.

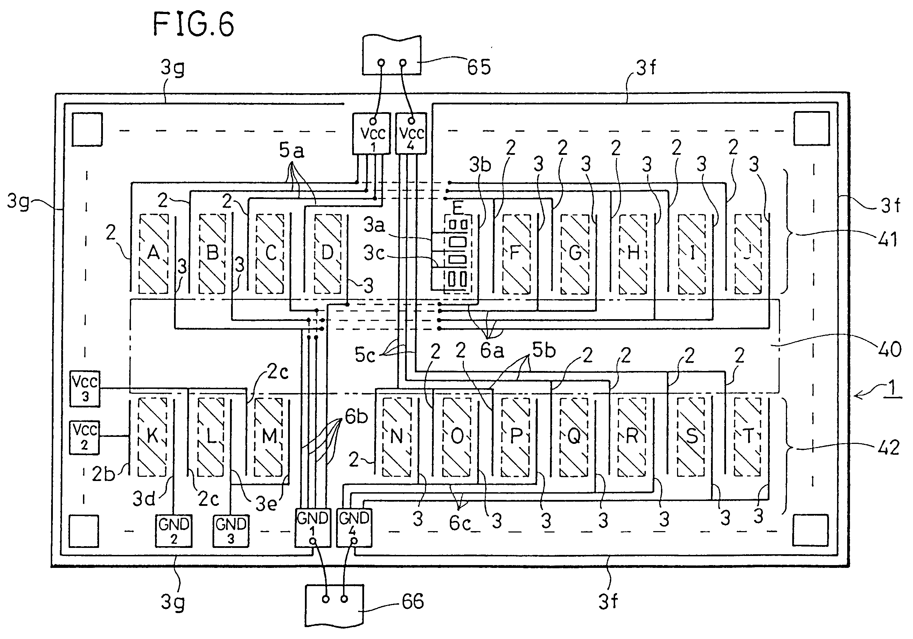

Referring to Fig. 6, a surface pattern of a semiconductor IC according to another embodiment of the present invention is schematically shown. The semiconductor IC in Fig. 6 is similar to that in Fig. 2, except that the semiconductor chip 1 is divided into equal regions, i.e., first and second regions 41 and 42 by a division region 40 shown by the double-dot chain lines. Mats A to J are formed in the first region 41 and mats K to T are formed in the second region 42. All circuit blocks 25 to 29 of the AM-FM stereo tuner shown in Fig. 4 are integrated in this semiconductor chip 1.

The FM front end block 25 including about 250 circuit elements is formed in the mats K, L, M. The FM-IF block 26 including about 430 circuit elements is formed in the mats E, F, G, H, I. The noise canceller block 27 including about 270 circuit elements is formed in the mats N, O, P. The multiplex decoder block 28 including about 390 circuit elements is formed in the mats Q, R, S, T. The AM tuner block 29 including about 350 circuit elements is formed in the mats A, B, C, D. The conductors 7a and 7b which interconnect the mats are not shown in Fig. 6 for the purpose of clarifying the illustration.

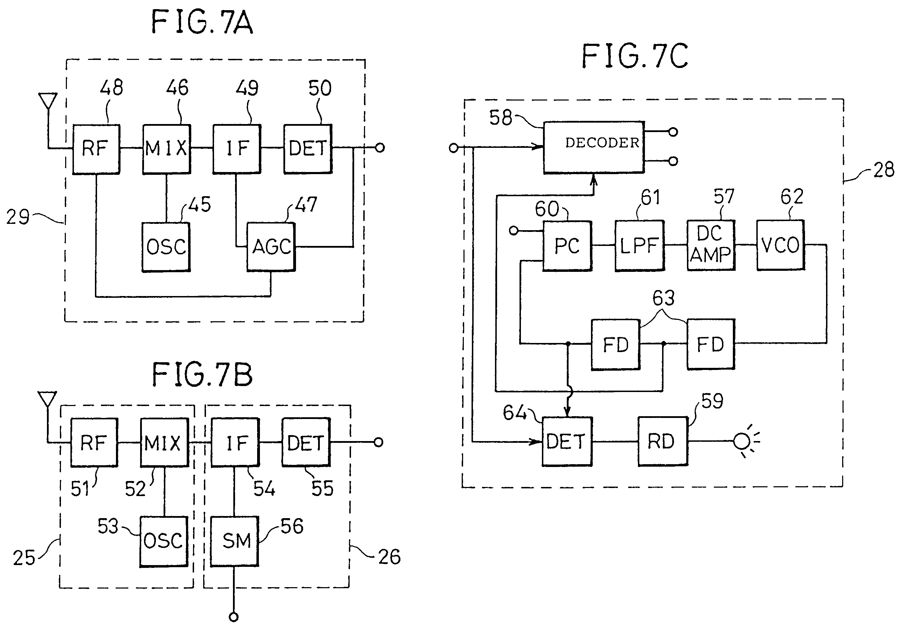

Referring to Figs. 7A, 7B and 7C, each of the AM block 29, the FM front end block 25, the FM-IF block 26 and the multiplex decoder block 28 is represented by a plurality of circuit sub blocks.

An oscillation circuit 45 in the AM tuner block 29 in Fig. 7A is formed in the mat A. A mixing circuit 46 is formed in the mat B. An automatic gain control circuit 47, a high frequency amplifying circuit 48 and an intermediate frequency amplifying circuit 49 are formed in the mat C. A detecting circuit 50 is formed in the mat D. A power supply line 2 extending along each of the mats A to D is connected to the corresponding one of the power supply lines of the bundle 5a extending along the upper side of the semiconductor chip 1 and connected to the first power supply pad Vcc1. A ground line 3 extending along each of the mats A to D is connected to the corresponding one of the ground lines of the bundle 6a extending along the upper side of the division region 40. Each ground line 6a on the division region 40 extends from the first ground pad GND1 through the mats M and N and it is connected to the corresponding one of the ground lines of the bundle 6b extending toward the division region 40.

As shown in Fig. 7B, the FM front end block 25 includes a high frequency amplifying circuit 51, a mixing circuit 52 and an oscillating circuit 53 and it processes a signal of a very low level such as several µV. Accordingly, the FM front end block 25 is liable to be adversely affected by other circuit blocks, particularly by the FM-IF block 26 and therefore the FM front end block 25 and the FM-IF block 26 are conventionally formed on different semiconductor chips. On the other hand, the oscillating circuit 53 in the FM front end block 25 might cause unnecessary radiation to exert adverse effect on other circuit blocks. Therefore, the mats K to M where the FM front end block 25 is formed are sufficiently spaced in a diagonal direction of the semiconductor chip 1 from the mats E to I where the FM-IF block 26 is formed.

The oscillating circuit 53 in the FM front end block 25 is formed in the mat K in the left lower corner of the semiconductor chip 1 in order to avoid mutual interference with other circuit blocks. Further, the power supply line 2b and the ground line 3a provided for the mat K are connected to a second power supply pad Vcc2 different from the first power supply pad Vcc1 and to a second ground pad GND2 different from the first ground pad GND1, respectively, in order to avoid mutual interference with other mats. The power supply line 2c and the ground line 3e extending along each of the mats L and M are connected to a third power supply pad Vcc3 and to a third ground pad GND3, respectively.

The FM-IF block 26 includes an intermediate frequency amplifying circuit 54, a detecting circuit 55 and an S meter 56. The detecting circuit 55 is formed in the mat I and the S meter 56 is formed in the mat G. A limiter circuit, a muting circuit and the like included in the intermediate frequency amplifying circuit 54 are formed in the mats E, F, G. Capacitors included in the limiter circuit for removing an AM signal component contained in an FM signal are collected and formed in the mat E in the same manner as in the semiconductor device in Fig. 2. However, the ground line 3a extending along the left side of the mat E is connected to a ground line 3f extending along peripheral regions of the semiconductor chip 1 in the counterclockwise direction from a fourth pad GND4 adjacent to the first ground pad GND1.

Since the ground line 3f is in ohmic contact with the underlying P⁺ separation region along the longitudinal direction thereof, it not only receives the leakage current of the mat E absorbed by the grounds line 3a and 3c but also absorbs the leakage current in the peripheral regions of the semiconductor chip 1. Similarly, a ground line 3g extending along peripheral regions of the semiconductor chip 1 in the clockwise direction from the first ground pad GND1 absorbs leakage current in the peripheral regions of the semiconductor chip 1.

The limiter circuit included in the intermediate frequency amplifying circuit 54 in the mats E to G has a very high gain of 80dB to 100dB. The detecting circuit 55 in the mat I and the S meter 56 in the mat H have high signal levels. Consequently, an undesirable feedback signal generated from the detecting circuit 55 and the S meter to the intermediate frequency amplifying circuit 54 might cause oscillation. Such oscillation would affect adversely the characteristics of the detecting circuit 55 and the S meter 56. Therefore, in order to prevent such adverse effect, two power supply lines 2 extending along the mats F and G including the intermediate frequency amplifying circuit 54 are connected to one of the power supply lines of the bundle 5a extending along the upper side of the semiconductor chip 1, while two power supply lines 2 extending along the mat I including the S meter 56 and along the mat H including the detecting circuit 50 are connected to another line of the bundle 5a. In addition, a power supply line 2 extending along the mat J where an optional circuit desired by the user is formed is connected to a further line of the bundle 5a.

Similarly, two ground lines 3 along the mats F and G are connected to one of the ground lines of the bundle 6a on the division region 40 and the two ground lines 3 along the mats H and I are connected to another line of the bundle 6a. The ground line 3 along the mat J is connected to a further line of the bundle 6a.

A DC amplifying circuit 57, a decoder circuit 58 and a ramp driver circuit 59 included in the multiplex decoder block 28 in Fig. 7C are formed in the mats Q and R. The remaining phase comparing circuit 60, low-pass filter 61, voltage control oscillator 62, frequency-dividing circuit 63 and detecting circuit 64 are formed in the mats S and T. The two power supply lines extending along the mats Q and R are connected to one of the power supply lines of the bundle 5b extending along the lower side of the division region 40, while the two power supply lines extending along the mats S and T are connected to another line of the bundle 5b. The three power supply lines 2 extending along the mats N, O and P including the noise canceller block are connected to a further line of the bundle 5b. Each line of the bundle 5b is connected to the corresponding one of the ground lines 5c extending from a fourth power line pad Vcc4 adjacent to the first power supply pad Vcc1 to the division region 40 through a region between the mats D and E.

Similarly, the two ground lines 3 extending along the mats Q and R are connected to one of the ground lines of the bundle 6c extending along the lower side of the semiconductor chip 1 from the fourth ground line GND4 and the two ground lines 3 extending along the mats S and T are connected to another line of the bundle 6c. The three ground lines extending along the mats N, O, P are connected to still another line of the bundle 6c.

The separate fourth power supply pad Vcc4 adjacent to the first power supply pad Vcc1 and the separate fourth ground pad GND4 adjacent to the first ground pad GND1 are provided to reduce mutual interference between the circuit blocks. Each of the first and fourth power supply pads Vcc1 and Vcc4 is connected to a power supply lead 65 through a fine metallic wire. Consequently, even if a pulse noise occurs in either of the first and fourth power supply pads Vcc1 and Vcc4, the pulse noise is attenuated by impedance of the two fine metallic wires and accordingly influence on the other power supply pad can be reduced. Similarly, the first and fourth ground pads GND1 and GND4 are connected to a ground lead 66 through respective fine metallic wires.

As described above, a sufficient space (where the bundle 5c of power supply lines extends) is provided between the mats D and E and a sufficient space (where the bundle 6b of ground lines extends) is provided between the mats M and N. Accordingly, the FM front end block 25 included in the mats K to M is sufficiently spaced from other circuit blocks, particularly, from the FM-IF block 26 included in the mats E to I, whereby mutual interference between the circuit blocks can be prevented. Further, the bundle 5c of power supply lines serves to shield from the above described unnecessary radiation. Since at least one line of each of the bundles 6a and 6b of ground lines is in ohmic contact with the underlying P⁺ separation region, it absorbs leakage current, where mutual interference due to leakage current can be prevented.

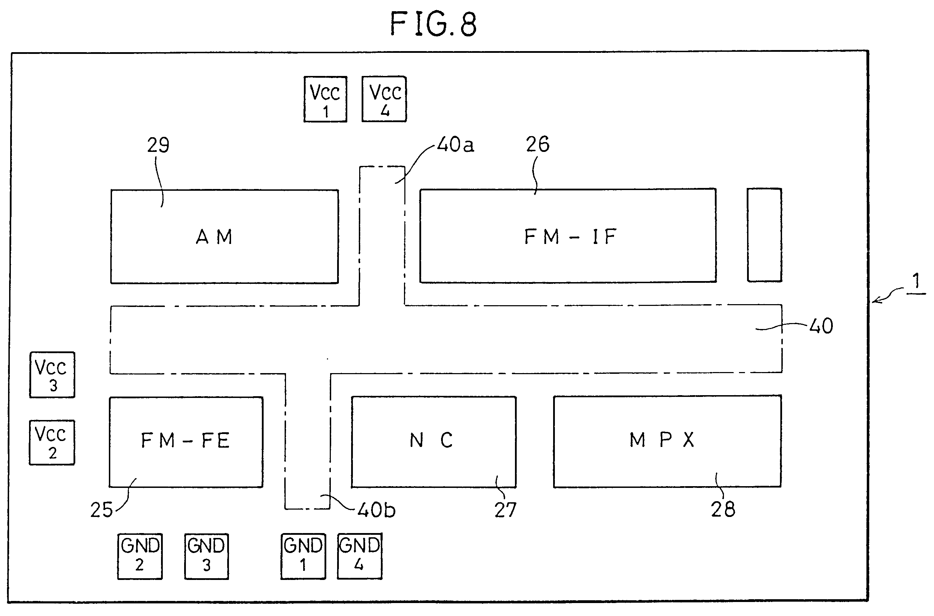

Referring to Fig. 8, a positional relation of circuit blocks of an AM/FM tuner formed on the semiconductor chip 1 is shown. The FM front end block 25 and the FM-IF block 26 where it is particularly necessary to prevent mutual interference are spaced sufficiently from each other in a diagonal direction of the semiconductor chip 1. The division region 40 may include an additional division region 40a extending between the AM tuner block 29 and the FM-IF block 26 and it may further include an additional division region 40b extending between the FM front end block 25 and the noise canceller block 27. Thus, the noise canceller block 27 and the multiplex decoder block 28 are also spaced sufficiently from the FM front end block 25 and the FM-IF block 26. In addition, the AM tuner block 29 is also spaced sufficiently from other circuit blocks 25 to 28.

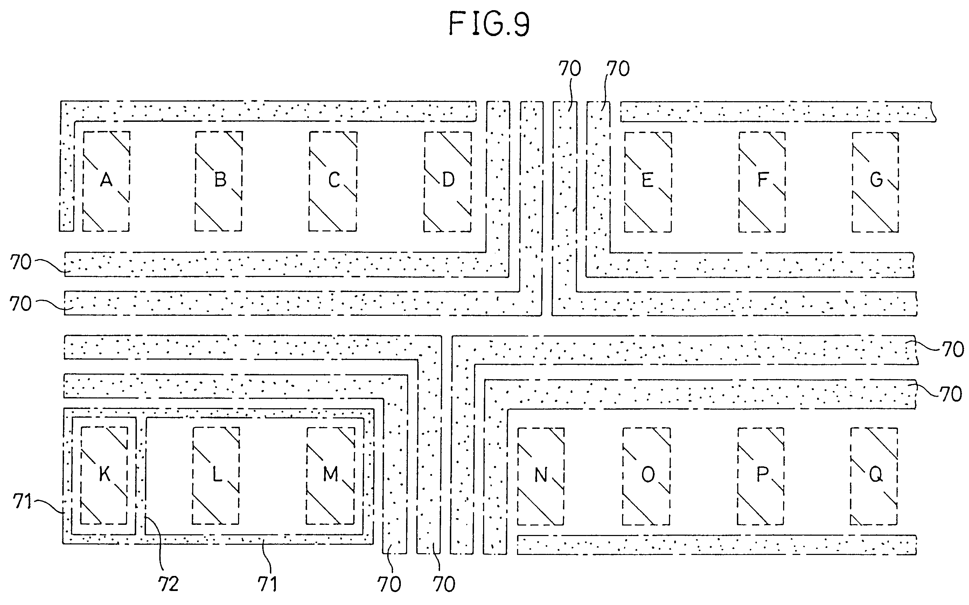

Referring to Fig. 9, a plurality of elongate dummy islands for enhancing the effect of preventing mutual interference of the circuit blocks are shown. The plurality of elongate N dummy islands 70 represented as being smudged are provided in spaces in the division regions 40, 40a, 40b. Those N dummy islands are surrounded by P⁺ separation regions at the ground potential and they are electrically independent of other N regions. Since barriers are formed by PN junctions formed around the dummy islands, resistance to leakage current is increased, making it possible to reduce mutual interferences of the mat groups A to D, E to J, K to M and N to T. The mats K, L, M where the FM front end block 25 is formed may be surrounded by a dummy island 71. In addition, a dummy island portion 72 may be added so that only the mat K including the oscillation circuit 53 may be surrounded entirely by the dummy islands.

Since the AM tuner block 29 does not operate simultaneously with the FM circuit section, it is not necessary to take account of mutual interference with the FM circuit section. Accordingly, the AM tuner block 29 included in the mats A to D and the FM-IF block 26 included in the mats E to I utilize in common the first power supply pad Vcc1, the first ground pad GND1 and the bundle 6b of ground lines. In consequence, the areas occupied by the bonding pads and conductors can be reduced.

The portions shown by the broken lines in the bundle 5a of power supply lines and the bundle 6a of ground lines in Fig. 6 represent conductors in the second layer as in Fig. 2.

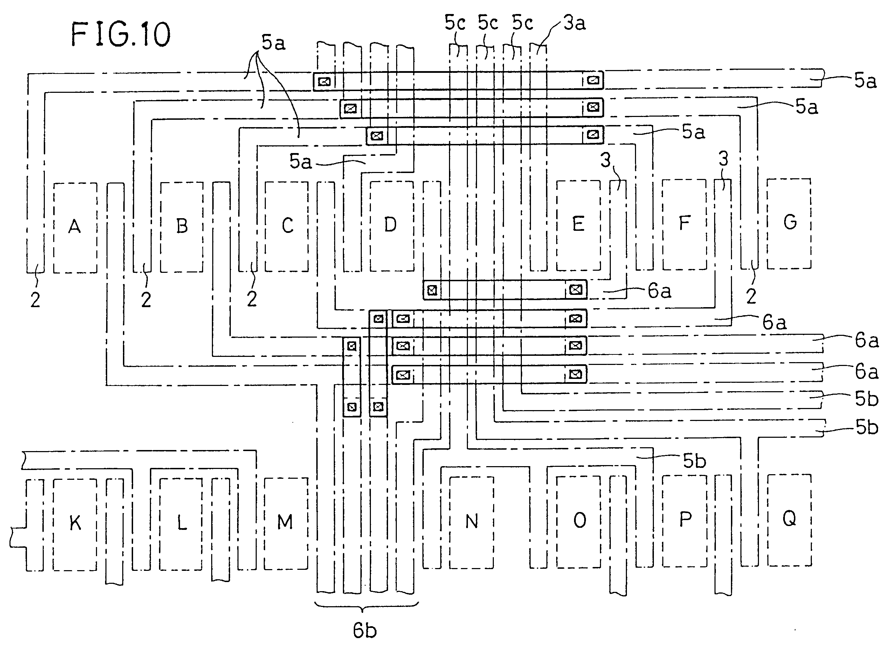

Referring to Fig. 10, the 2-level crossing of the power supply lines and the ground lines in Fig. 6 is schematically illustrated. The conductors represented by the single-dot chain lines exist in the first layer and the conductors represented by the solid lines exist in the second layer. The conductors in the first and second layers are connected through contact regions shown by the marks x. In consequence, the bundle 5a of power supply lines and the bundle 6a of ground lines cross over the bundle 5c of power supply lines.

If the AM tuner block 29 is not required, the multiplex decoder block 28 can be shifted from the mats Q to T to the mats A to D. In that case, it is not needed to entirely change the arrangements of the circuit elements and conductors in the multiplex decoder block 28 and only the conductors between the circuit blocks need to be rearranged. Similarly, if the circuits in the mats I and J are shifted to the vacant mats Q and R, the four mats I, J, S and T at the right end are not required.

If an improvement is made only in the mat F of the FM-IF block 26 for example, it is only necessary to redesign the mat F and no change is required for the other mats.

In addition, if a user desires an additional circuit block in addition to the optional mat J, only a necessary number of mats need to be added.

Thus, according to the present invention, since mats of the substantially same size are arranged in a line form or a matrix form on the semiconductor chip, it is easy to change, add and delete circuit blocks as required. Accordingly, circuit blocks to be used in an electronic circuit of a large scale can be individually designed and stocked. As a result the time required for design of a large-scale electronic circuit can be considerably reduced and a high reliability can be maintained.

In addition, if capacitors each having a relatively large area are formed in one mat, forms and arrangements of other circuit elements such as transistors, diodes and resistors do not need to be taken into account and thus it becomes easy to design the capacitors. In consequence, it is not needed to take account of leakage current from the capacitors in the mats not including the capacitors and it becomes easy to design circuits in those mats.

Referring to Fig. 11A, a semiconductor IC according to a further embodiment of the present invention is schematically shown. In this figure, interconnections between the mats are not shown for the purpose of simplification of the illustration. An electronic circuit often includes first and second circuit sections which do not operate simultaneously, as in the above described case of the AM and FM sections in the AM/FM stereo tuner. It is often necessary to prevent mutual interference between circuit blocks in the same section. The embodiment in Fig. 11A is preferable for such cases. The semiconductor IC of Fig. 11A is similar to that of Fig. 2, except that alternate mats A, C, E and G include a circuit block in a first circuit section and the other alternate mats B, D, F and H include a circuit block in a second circuit section. More specifically, one of the mats of the second circuit section is located between the adjacent mats of the first circuit section and one of the mats of the first circuit section is located between the adjacent mats of the second circuit section.

When the mats A, C, E, G including the first circuit section are in operation, the mats B, D, F of the second circuit section between the corresponding ones of the mats A, C, E, G are not operated and they are in a high impedance state. Thus, mutual interference between the respective mats A, C, E, G of the first circuit section is suppressed. On the other hand, when the mats B, D, F, H including the second circuit sections are in operation, the mats C, E, G of the first circuit section are not operated and in a high impedance state. Accordingly, mutual interference between the mats B, D, F, H of the second circuit section is suppressed.

The mats not in operation each function as a large capacitor of a PN junction type per se and serve to remove high frequency noise. For example, even if high frequency noise enters the P⁻ semiconductor substrate 15 through the mat A, the mat B functions as a large PN junction type capacitor and the noise is absorbed through the power supply line 2 connected to the mat B. As a result, mutual interference between the mats A and C due to the high frequency noise can be prevented.

In addition, since the power supply line 2 for the mat A and the power supply line 2 for the mat C for example are connected in parallel with each other to the first power supply pad Vcc1, any change in the potential in the mat A is not transmitted directly to the mat C.

Referring to Fig. 11B, a semiconductor IC according to a still further embodiment of the invention is schematically shown. Although the semiconductor IC of Fig. 11B is similar to that of Fig. 11A, there are differences in that a circuit block in the first circuit section is formed in the mats A, B, E, F and that a circuit block in the second circuit section is formed in the mats C, D, G, H. Thus, two mats of the first circuit section and two mats of the second circuit section are arranged in turn. In the semiconductor IC of Fig. 11B, the group of the mats A and B and that of the mats E and F of the first circuit section can be spaced sufficiently. Similarly, the group of the mats C and D and that of the mats G and H of the second circuit section can be spaced sufficiently.

## Claims

1. A semiconductor integrated circuit comprising: a semiconductor chip (1), a plurality of layout areas (A to T) of substantially equal size formed in said semiconductor chip, each of said layout areas being capable of containing a plurality of circuit elements (10 to 13), partition regions (4) arranged between adjacent layout areas for separating said layout areas (A to T) from each other, and a pair of supply lines consisting of one power line (2) and one ground line (3) provided on each of said partition regions (4), an electronic circuit formed in said semiconductor chip, **characterized** in that said electronic circuit includes circuit blocks each comprising an analog circuit having different circuit configurations and circuit functions, said circuit blocks being designed by using each of said layout areas (A to T) as a unit, said layout areas containing a preferable number of circuit elements according to circuit blocks incorporated in said semiconductor chip such that a plurality of said circuit blocks are constituted by groups of two or more layout areas, wherein in each group of layout areas only one circuit block is arranged.

2. A semiconductor integrated circuit in accordance with claim 1, wherein the power supply lines (2) on said partition regions (4) extend from a bundle (5, 5a, 5b) of power supply lines in a comb-teeth form and the ground lines (3) on said partitions regions (4) also extend from a bundle (6, 6a, 6c) of ground lines in a comb-teeth form, the comb-theeth form of said power supply lines (2, 5, 5a, 5b) and the comb-teeth form of said ground lines (3, 6, 6a, 6c) being opposite to each other.

3. A semiconductor integrated circuit in accordance with claim 2, wherein said power supply lines (2, 5, 5a, 5b) and said ground lines (3, 6, 6a, 6c) are formed substantially by conductors in a first conductor layer.

4. A semiconductor integrated circuit in accordance with claim 3, wherein circuit elements in each of said layout areas (A to T) are interconnected substantially by conductors (8) in the first conductor layer and said layout areas (A to T) are interconnected substantially by conductors (7a) in a second conductor layer.

5. A semiconductor integrated circuit in accordance with claim 4, wherein said layout areas (A to T) are interconnected by the conductors (7a) in the second conductor layer connected to both ends of a conductor segment (7b) in the first conductor layer provided between the power supply line (2) and the ground line (3) of said pair.

6. A semiconductor integrated circuit in accordance with claim 1, wherein said semiconductor chip (1) is divided into first and second regions (41, 42) each comprising a plurality of said layout areas (A-J; K-T); said first and second regions being spaced from each other by a division region (40).

7. A semiconductor integrated circuit in accordance with claim 1, wherein at least one layout area of said plurality of layout areas (A to T) is a capacitor layout area (E) including only capacitors (13) as circuit elements.

8. A semiconductor integrated circuit in accordance with claim 7, wherein ground lines (3a, 3b, 3f, 6a) are provided on at least one side of said capacitor layout area (E) and said ground lines (3a, 3b, 3f, 6a) along the total lengths thereof are in ohmic contact with doped separation regions (17) lying under said ground lines for absorbing leakage currents.

9. A semiconductor integrated circuit in accordance with claim 7, wherein each of said capacitors (13) is formed in an island (18) surrounded by doped separation regions (17).

10. A semiconductor integrated circuit in accordance with claim 8, wherein ground lines (3c) are further provided to extend in a comb-teeth form from at least one of the ground lines (3a) on at least one side of said capacitor layout area (E) and said ground lines (3c) in the comb-theeth form are in ohmic contact with underlying doped separation regions (17).

11. A semiconductor integrated circuit in accordance with claim 8, wherein said capacitor layout area (E) is disposed at one end of a group of the layout areas (E to I) constituting one circuit block.

12. A semiconductor integrated circuit in accordance with claim 1, wherein two circuit blocks (25, 26), where it is necessary to prevent mutual interference, are formed in two groups of layout areas (E to I and K to M) spaced from each other in a diagonal direction of said semiconductor chip (1).

13. A semiconductor integrated circuit in accordance with claim 12, wherein said electronic circuit is an AM/FM stereo tuner and the two circuit blocks where it is necessary to prevent mutual interference are an FM front end block (25) and an FM-IF block (26).

14. A semiconductor integrated circuit in accordance with claim 13, wherein an oscillating circuit (53) included in said FM front end block (25) is formed in the layout area (K) at a corner of a rectangular semiconductor chip (1).

15. A semiconductor integrated circuit in accordance with claim 6, wherein groups of layout areas (A to D, E to I; K to M, N to P) are formed in either said first region or said second region (41, 42); said groups of layout areas being spaced from each other, and wherein a bundle (5c, 6b) of conductors being arranged in each space between adjacent groups.

16. A semiconductor integrated circuit in accordance with claim 6, wherein one or more elongate dummy islands which are islands surrounded by separation regions at ground potential but do not contain any circuit element are provided in said division region (40).

17. A semiconductor integrated circuit in accordance with claim 15, wherein one or more elongate dummy islands which are islands surrounded by separation regions at ground potential but do not contain any circuit element are provided under each said space where said bundle of conductors (5c, 6b) is disposed.

18. A semiconductor integrated circuit in accordance with claim 13, wherein the layout area group (K to M) including said FM front end block (25) is surrounded by dummy islands (71) which are islands surrounded by separation regions at ground potential but do not contain any circuit element.

19. A semiconductor integrated circuit in accordance with claim 14, wherein the layout area including the oscillating circuit (53) included in said FM front end block (25) is entirely surrounded by dummy islands (71, 72) wich are islands surrounded by separation regions at ground potential but do not contain any circuit element.

20. A semiconductor integrated circuit in accordance with claim 6, wherein said electronic circuit includes first and second circuit blocks (29, 26) not operating simultaneously and a third circuit block (28) operating at all times, the layout areas (A to D, E to I) constituting said first and second circuit blocks (29, 26) utilize in common a first power supply pad (Vcc1) and a first ground pad (GND1) on said semiconductor chip (1), and the layout areas (Q to T) constituting said third circuit block utilize a second power supply pad (Vcc4) and a second ground pad (GND4).

21. A semiconductor integrated circuit in accordance with claim 20, wherein said electronic circuit is an FM/AM stereo tuner, said first and second circuit blocks are an AM tuner block (29) and an FM-IF block (26), and said third circuit block is a multiplex decoder block (28).

22. A semiconductor integrated circuit in accordance with claim 20, wherein said semiconductor integrated circuit further comprises a power supply lead (65) and a ground lead (66) provided from outside the chip, said first and second power supply pads (Vcc1, Vcc4) are disposed adjacent to each other on said semiconductor chip (1) and each of said pads is connected to said power supply lead (65) by a single fine metallic wire, and said first and second ground pads (GND1, GND4) are provided adjacent to each other and each of said pads is connected so said ground lead (66) by a single fine metallic wire.

23. A semiconductor integrated circuit in accordance with claim 1, wherein said electronic circuit includes first and second circuit sections which are free from operating simultaneously, each of said circuit sections including at least one circuit block having a plurality of said layout areas, at least one of said layout areas of said one of said circuit sections being formed between two of the layout areas of the other circuit section.

24. A semiconductor integrated circuit in accordance with claim 23, wherein the layout areas of said first circuit section and the layout areas of said second circuit section are arranged alternately along a row of layout areas .

## Patentansprüche

1. Integrierte Halbleiterschaltung mit:
einem Halbleiterchip (1), einer Anzahl von Layoutflächen (A-T) von im wesentlichen gleicher Größe, die in dem Halbleiterchip ausgebildet sind, wobei jede der Layout-Flächen in der Lage ist, eine Anzahl von Schaltungselementen (10-13) zu enthalten, Teilungsbereichen (4), die zwischen angrenzenden Layoutflächen angeordnet sind, um die Layoutflächen (A-T) voneinander zu trennen, und einem Paar Zufuhrleitungen aus einer Versorgungsleitung (2) und einer Massenleitung (3), die in jedem der Teilungsbereiche (4) vorgesehen sind, einer elektronischen Schaltung, die in dem Halbleiterchip ausgebildet ist,
dadurch **gekennzeichnet,** daß die elektronische Schaltung Schaltungblöcke aufweist, von denen jeder eine analoge Schaltung mit unterschiedlichen Schaltungsaufbauten und Schaltungsfunktionen aufweist, wobei die Schaltungblöcke unter Einsatz jeder der Layoutflächen (A-T) als Einheit entworfen sind, wobei die Layoutflächen eine bevorzugte Anzahl von Schaltungselementen entsprechend Schaltungsblöcken aufweist, die in dem Halbleiterchip eingefügt sind, so daß eine Anzahl der Schaltungsblöcke durch Gruppen von zwei oder mehr Layoutflächen gebildet sind, wobei in jeder Gruppe von Layoutflächen nur ein Schaltungsblock angeordnet ist.

2. Integrierte Halbleiterschaltung nach Anspruch 1,
wobei die Versorgungszufuhrleitungen (2) auf den Teilbereichen (4) sich von einem Bündel (5, 5a, 5b) von Versorgungszufuhrleitungen in Kammzahnform erstrecken und sich die Massenleitungen (3) auf den Teilbereichen (4) ebenfalls von einem Bündel (6, 6a, 6c) von Massenleitungen in Kammzahnform erstrecken, wobei die Kammzahnform der Versorgungszufuhrleitungen (2, 5, 5a, 5b) und die Kammzahnform der Massenleitungen (3, 6, 6a, 6c) einander entgegengesetzt sind.

3. Integrierte Halbleiterschaltung nach Anspruch 2,
wobei die Versorgungszufuhrleitungen (2,5, 5a, 5b) und die Massenleitungen (3, 6, 6a, 6c) im wesentlichen durch Leiter in einer ersten Leitungsschicht gebildet sind.

4. Integrierte Halbleiterschaltung nach Anspruch 3,
wobei Schaltungselemente in jeder der Layoutflächen (A-T) im wesentlichen durch Leiter (8) in der ersten Leitungsschicht miteinander verbunden sind und wobei die Layoutflächen (A-T) im wesentlichen durch Leiter (7a) in einer zweiten Leitungsschicht miteinander verbunden sind.

5. Integrierte Halbleiterschaltung nach Anspruch 4,
wobei die Layoutflächen (A-T) durch Leiter (7a) in der zweiten Leitungsschicht verbunden sind, die mit beiden Enden eines Leitungssegments (7b) in der ersten Leitungsschicht verbunden sind, die zwischen der Versorgungszufuhrleitung (2) und der Massenleitung (3) des Paares vorgesehen sind.

6. Integrierte Halbleiterschaltung nach Anspruch 1,
wobei der Halbleiterchip (1) in einen ersten und in einen zweiten Bereich (41, 42) unterteilt ist, von denen jeder eine Anzahl der Layoutflächen (A-J; K-T) aufweist, wobei der erste und der zweite Bereich voneinander durch einen Unterteilungsbereich (40) beabstandet sind.

7. Integrierte Halbleiterschaltung nach Anspruch 1,
wobei zumindest eine Layoutfläche der Anzahl von Layoutflächen (A-T) eine Kondensatorlayoutfläche (E) ist, die nur Kondensatoren (13) als Schaltungselemente enthält.

8. Integrierte Halbleiterschaltung nach Anspruch 7,
wobei Masseleitungen (3a, 3b, 3f, 6a) an zumindest einer Seite der Kondensatorlayoutfläche (E) vorgesehen sind und diese Masseleitungen (3a, 3b, 3f, 6a) zum Absorbieren von Leckströmen entlang ihrer Gesamtlängen in ohmschem Kontakt mit dotierten Trennbereichen (17) sind, die unter den Masseleitungen liegen.

9. Integrierte Halbleiterschaltung nach Anspruch 7,
wobei jeder der Kondensatoren (13) in einer Insel (18) gebildet ist, die durch dotierte Trennbereiche (17) umgeben ist.

10. Integrierte Halbleiterschaltung nach Anspruch 8,
wobei Masseleitungen (3c) zur Erstreckung in einer Kammzahnform von zumindest einer der Massenleitungen (3a) an zumindest einer Seite der Kondensatorlayoutfläche (E) vorgesehen sind, und wobei die Masseleitungen (3c) in der Kammzahnform in ohmschem Kontakt mit unterliegenden dotierten Trennbereichen (17) stehen.

11. Integrierte Halbleiterschaltung nach Anspruch 8,
wobei die Kondensatorlayoutflächen (E) an einem Ende einer Gruppe der Layoutflächen (E-I) angeordnet ist, die einen Schaltungsblock bilden.

12. Integrierte Halbleiterschaltung nach Anspruch 1,
wobei zwei Schaltungsblöcke (25, 26), wenn es erforderlich ist, gegenseitige Interferenz zu verhindern, in zwei Gruppen von Layoutflächen (E-I und K-M) ausgebildet sind, die in Diagonalrichtung des Halbleiterchips (1) voneinander beabstandet sind.

13. Integrierte Halbleiterschaltung nach Anspruch 12,
wobei die elektronische Schaltung ein AM-FM-Stereotuner ist und die beiden Schaltungsblöcke, bei denen es erforderlich ist, gegenseitige Interferenz zu verhindern, ein FM-Frontendblock (25) und ein FM-IF-Block (26) sind.

14. Integrierte Halbleiterschaltung nach Anspruch 13,
wobei eine Oszillatorschaltung (53), die in dem FM-Frontendblock (25) enthalten ist, in der Layoutfläche (K) an einer Ecke eines rechteckigen Halbleiterchips (1) ausgebildet ist.

15. Integrierte Halbleiterschaltung nach Anspruch 6,
wobei Gruppen von Layoutflächen (A-D, E-I, K-M, N-P) entweder in dem ersten Bereich oder in dem zweiten Bereich (41, 42) ausgebildet sind, wobei diese Gruppen von Layoutflächen voneinander beabstandet sind und wobei ein Bündel (5c, 6b) von Leitern in jedem Raum zwischen aneinandergrenzenden Gruppen angeordnet ist.

16. Integrierte Halbleiterschaltung nach Anspruch 6,
wobei eine oder mehrere längliche Dummyinseln, die Inseln sind, die von Trennbereichen mit Massepotential umgeben sind, aber kein Schaltungselement enthalten, in dem Unterteilungsbereich (40) vorgesehen sind.

17. Integrierte Halbleiterschaltung nach Anspruch 15,
wobei eine oder mehrere längliche Dummyinseln, die Inseln sind, die durch Trennbereiche mit Massepotential umgeben sind, aber kein Schaltungselement enthalten, unter jedem der Räume vorgesehen sind, wo das Bündel von Leitern (5c, 5b) angeordnet ist.

18. Integrierte Halbleiterschaltung nach Anspruch 13,
wobei die Layoutflächengruppe (K-M), die den FM-Frontendblock (25) enthält, durch Dummyinseln (71) umgeben ist, die Inseln sind, die von Trennbereichen mit Massenpotential umgeben sind, aber keine Schaltungselemente enthalten.

19. Integrierte Halbleiterschaltung nach Anspruch 14,
wobei die Layoutfläche, die die Oszillationsschaltung (53) des FM-Frontendblocks (25) enthält, vollständig durch Dummyinseln (71, 72) umgeben ist, die Inseln sind, die durch Trennbereiche mit Massenpotential umgeben sind, aber kein Schaltungselement enthalten.

20. Integrierte Halbleiterschaltung nach Anspruch 6,
wobei die elektronische Schaltung einen ersten und einen zweiten Schaltungsblock (21, 26) enthält, die nicht gleichzeitig betrieben werden, und einen dritten Schaltungsblock (25), der immer betrieben wird, wobei die Layoutflächen (A-D, E-I), die den ersten und den zweiten Schaltungsblock (29, 26) bilden, gemeinsam ein erstes Versorgungskissen (Vcc1) und ein erstes Massekissen (GND1) auf dem Halbleiterchip (1) nutzen und die Layoutflächen (Q-T), die den dritten Schaltungsblock bilden, ein zweites Versorgungskissen (Vcc4) und ein zweites Massekissen (GND4) nutzen.

21. Integrierte Halbleiterschaltung nach Anspruch 20,
wobei die elektronische Schaltung ein FM-AM-Stereotuner ist, wobei der erste und der zweite Schaltungsblock ein AM-Tunerblock (29) und ein FM-IF-Block (26) sind und der dritte Schaltungsblock ein Multiplex-Dekoderblock (28) ist.

22. Integrierte Halbleiterschaltung nach Anspruch 20,
wobei die integrierte Halbleiterschaltung weiterhin eine Versorgungsleitung (65) und eine Masseleitung (66) aufweist, die von außerhalb des Chips zugeführt werden, wobei die ersten und zweiten Versorgungskissen (Vcc1, Vcc4) angrenzend aneinander auf dem Halbleiterchip (1) angeordnet sind und jedes der Kissen mit der Versorgungsleitung (65) durch einen einzelnen feinen Metalldraht verbunden sind, und das erste und das zweite Massekissen (GND1, GND4) angrenzend aneinander angeordnet sind und jedes dieser Kissen mit der Masseleitung (66) durch einen einzelnen feinen Metalldraht verbunden ist.

23. Integrierte Halbleiterschaltung nach Anspruch 1,
wobei die elektronische Schaltung einen ersten und einen zweiten Schaltungsabschnitt aufweist, die nicht gleichzeitig arbeiten, wobei jeder der Schaltungsabschnitte zumindest einen Schaltungsblock aufweist, der eine Anzahl von Layoutflächen aufweist, wobei zumindest eine der Layoutflächen des einen der Schaltungsabschnitte zwischen zwei der Schaltungsflächen des anderen Schaltungsabschnitts ausgebildet ist.

24. Integrierte Halbleiterschaltung nach Anspruch 23,
wobei die Layoutflächen des ersten Schaltungsabschnitts und die Layoutflächen des zweiten Schaltungsabschnitts abwechselnd entlang einer Reihe von Layoutflächen angeordnet sind.

## Revendications

1. Circuit intégré semi-conducteur comportant:
une plaquette de semi-conducteur (1), une pluralité de zones d'agencement (A à T) de dimensions essentiellement égales formées dans la dite plaquette de semi-conducteur, chacune desdits zones d'agencements pouvant contenir une pluralité d'éléments de circuit (10 à 13), des régions de partage (4) disposées entre des zones d'agencement adjacentes pour séparer lesdites zones d'agencement (A à T) les unes des autres, et une paire de lignes d'alimentation consistant en une ligne d'alimentation en puissance (2) et une ligne de mise à la masse (3) prévues sur chacune desdites régions de partage (4), un circuit électronique formé dans ladite plaquette de semi-conducteur,
caractérisé ne ce que
ledit circuit électronique comporte des blocs de circuits comportant chacun un circuit analogique ayant différentes configurations de circuit et fonctions de circuits, lesdits blocs de circuit étant conçus en utilisant chacune desdites zones d'agencement (A à T) comme unité, lesdites zones d'agencement contenant un nombre préférable d'éléments de circuits selon des blocs de circuit incorporés dans ladite plaquette de semi-conducteur de sorte qu'une pluralité desdits blocs de circuit soient constitués par des groupes de deux zones d'agencement ou plus, dans lequel, dans chaque groupe de zones d'agencement, seul un bloc de circuit est disposé.

2. Circuit intégré semi-conducteur selon la revendication 1, dans lequel les lignes d'alimentation en puissance (2) sur lesdites régions de partage (4) s'étendent à partir d'un faisceau (5, 5a, 5b) de lignes d'alimentation en puissance en dents de peigne, et les lignes de mise à la masse (3) sur lesdites régions de partage (4) s'étendent aussi à partir d'un faisceau (6, 6a, 6b) de lignes de mise à la masse en dents de peigne, la forme en dents de peigne desdites lignes d'alimentation en puissance (2, 5, 5a, 5b) et la forme en dents de peigne desdites lignes de mise à la masse (3, 6, 6a, 6c) étant opposées l'une à l'autre.

3. Circuit intégré semi-conducteur selon la revendication 2, dans lequel lesdites lignes d'alimentation en puissance (2, 5, 5a, 5b) et lesdites lignes de mise à la masse (3, 6, 6a, 6b) sont formées essentiellement par des conducteurs dans une première couche conductrice.

4. Circuit intégré semi-conducteur selon la revendication 3, dans lequel des éléments de circuit dans chacune desdites zones d'agencement (A à T), sont interconnectés essentiellement par des conducteurs (8) dans la première couche conductrice, et lesdites zones d'agencement (A à T) sont interconnectées essentiellement par des conducteurs (7a) dans une seconde couche conductrice.

5. Circuit intégré semi-conducteur selon la revendication 4, dans lequel lesdites zones d'agencement (A à T) sont interconnectées par les conducteurs (7a) dans la seconde couche conductrice connectée aux deux extrémités d'un segment conducteur (7b) dans la première couche conductrice prévue entre la ligne d'alimentation en puissance (2) et la ligne de mise à la masse (3) de ladite paire.

6. Circuit intégré semi-conducteur selon la revendication 1, dans lequel ladite plaquette de semi-conducteur (1) est divisée en des première et seconde régions (41, 42), chacune comportant une pluralité desdites zones d'agencement (A-J; K-T); lesdites première et seconde régions étant espacées l'une de l'autre par une région de division (40).

7. Circuit intégré semi-conducteur selon la revendication 1, dans lequel au moins une zone d'agencement de ladite pluralité de zones d'agencement (A à T) est une zone d'agencement de capacité (E) incluant seulement des capacités (13) comme éléments de circuit.

8. Circuit intégré semi-conducteur selon la revendication 7, dans lequel des lignes de mise à la masse (3a, 3b, 3f, 6a) sont prévues sur au moins un côté de ladite zone d'agencement de capacité (E) et lesdites lignes de mise à la masse (3a, 3b, 3f, 6a) le long de leurs longueurs totales, sont en contact ohmique avec des régions de séparation dopées (17) s'étendant sous lesdites lignes de mise à la masse pour absorber des courants de fuite.

9. Circuit intégré semi-conducteur selon la revendication 7, dans lequel chacune desdites capacités (13) est formée en île (18) entourée par des régions de séparation dopées (17).

10. Circuit intégré semi-conducteur selon la revendication 8, dans lequel des lignes de mise à la masse (3c) sont en outre prévues pour s'étendre en dents de peigne à partir d'au moins une des lignes de mise à la masse (3a) sur au moins un côté de ladite zone d'agencement de capacité (E), et lesdites lignes de mise à la masse (3c) en dents de peigne sont en contact ohmique avec des régions de séparation dopées en sous-couche (17).

11. Circuit intégré semi-conducteur selon la revendication 8, dans lequel ladite zone d'agencement de capacité (E) est disposée à une extrémité d'un groupe de zones d'agencement (E à I) constituant un bloc de circuit.

12. Circuit intégré semi-conducteur selon la revendication 1, dans lequel deux blocs de circuit (25, 26), où il est nécessaire d'éviter des interférences mutuelles, sont formés dans deux groupes de zones d'agencement (E à I et K à M) espacés l'un de l'autre dans une direction diagonale de la dite plaquette de semi-conducteur (1).

13. Circuit intégré semi-conducteur selon la revendication 12, dans lequel ledit circuit électronique est un tuner stéréo AM/FM et les deux blocs de circuit où il est nécessaire d'éviter des interférences mutuelles, sont un bloc d'entrée FM (25) et un bloc FM-IF (26).

14. Circuit intégré semi-conducteur selon la revendication 13, dans lequel un circuit oscillant (53) inclus dans ledit bloc d'entrée FM (25), est formé dans la zone d'agencement (K) à un coin d'une plaquette de semi-conducteur rectangulaire (1).

15. Circuit intégré semi-conducteur selon la revendication 6, dans lequel des groupes de zones d'agencement (A à D, E à I; K à M, N à P) sont formés dans l'une ou l'autre desdites première et seconde régions (41, 42); lesdits groupes de zones d'agencement étant espacés les uns des autres, et dans lequel un faisceau (5c, 6b) de conducteurs est disposé dans chaque espace entre des groupes adjacents.

16. Circuit intégré semi-conducteur selon la revendication 6, dans lequel une ou plusieurs îles factices allongées, qui sont des îles entourées par des régions de séparation au potentiel de la masse, mais qui ne contiennent aucun élément de circuit, sont prévues dans ladite région de division (40).

17. Circuit intégré semi-conducteur selon la revendication 15, dans lequel une ou plusieurs îles factices allongées, qui sont des îles entourées par des régions de séparation au potentiel de la masse, mais qui ne contiennent aucun élément de circuit, sont prévues sous chacun desdits espaces où ledit faisceau de conducteurs (5c, 6b) est disposé.

18. Circuit intégré semi-conducteur selon la revendication 13, dans lequel le groupe de zones d'agencement (K à M) incluant ledit bloc d'entrée FM (25) est entouré par des îles factices (71) qui sont des îles entourées par des régions de séparation au potentiel de la masse mais qui ne contiennent aucun élément de circuit.

19. Circuit intégré semi-conducteur selon la revendication 14, dans lequel la zone d'agencement incluant le circuit oscillateur (53) inclus dans ledit bloc d'entrée FM (25) est entièrement entouré par des îles factices (71, 72) qui sont des îles entourées par des régions de séparation au potentiel de la masse, mais qui ne contiennent aucun élément de circuit.

20. Circuit intégré semi-conducteur selon la revendication 6, dans lequel ledit circuit électronique comporte des premiers et second blocs de circuit (29, 26) ne fonctionnant pas simultanément, et un troisième bloc de circuit (28) fonctionnant tout le temps, les zones d'agencement (A à D, E à I) constituant lesdits premier et second blocs de circuit (29, 26), utilisent en commun une première ligne d'alimentation en puissance (Vcc1) et une première ligne de mise à la masse (GND1) sur ladite plaquette de semi-conducteur (1), et les zones d'agencement (Q à T) constituant ledit troisième bloc de circuit, utilisent une seconde ligne d'alimentation en puissance (Vcc4) et une seconde ligne de mise à la masse (GND4)

21. Circuit intégré semi-conducteur selon la revendication 20, dans lequel ledit circuit électronique est un tuner stéréo FM/AM, lesdits premier et second blocs de circuit sont un bloc de tuner AM (29) et un bloc FN-IF (26), et ledit troisième bloc de circuit est bloc décodeur multiplex (28).

22. Circuit intégré semi-conducteur selon la revendication 20, dans lequel ledit circuit intégré semi-conducteur comporte en outre un conducteur d'alimentation en puissance (65) et un conducteur de masse (66) prévus à partir de l'extérieur de la plaquette, lesdites première et seconde lignes d'alimentation en puissance (Vcc1, Vcc4) sont disposées adjacents l'une à l'autre sur ladite plaquette de semi-conducteur (1), et chacune de ces dites lignes est connectée audit conducteur d'alimentation en puissance (65) par un fil métallique fin unique, et lesdites première et seconde lignes de mise à la masse (GND1, GND4) sont prévues adjacentes l'une à l'autre, et chacune de ces dites lignes est connectée audit conducteur de mise à la masse (66) par un fil métallique fin unique.

23. Circuit intégré semi-conducteur selon la revendication 1, dans lequel ledit circuit électronique inclut des première et seconde sections de circuit qui sont libres de fonctionner simultanément, chacune de ces dites sections de circuit incluant au moins un bloc de circuit ayant une pluralité de dites zones d'agencement, au moins une desdites zones d'agencement d'une des dites sections de circuit, étant formée entre deux des zones d'agencement de l'autre section de circuit.

24. Circuit intégré semi-conducteur selon la revendication 23, dans lequel les zones d'agencement de ladite première section de circuit et les zones d'agencement de ladite seconde section de circuit sont disposées alternativement le long d'une rangée de zones d'agencement.
